# EUROPÄISCHE PATENTSCHRIFT

(11) **EP 2 059 421 B1**
(45) Veröffentlichungstag und Bekanntmachung des Hinweises auf die Patenterteilung: **28.12.2011**
(21) Anmeldenummer: 07802935.2
(22) Anmeldetag: 28.08.2007
(51) Int. Cl.: B60R 25/00, E05B 65/20, G07C 9/00, H03K 17/96

(54) **HANDHABE**
HANDLE
MANETTE

(30) Priorität: 06.09.2006 DE 102006042152
(43) Veröffentlichungstag der Anmeldung: 20.05.2009
(73) Patentinhaber: Huf Hülsbeck & Fürst GmbH & Co. KG, 42551 Velbert (DE)
(72) Erfinder: LANGE, Stefan, 42579 Heiligenhaus (DE)
(74) Vertreter: Vogel, Andreas
(86) Internationale Anmeldenummer: PCT/EP2007/058899
(87) Internationale Veröffentlichungsnummer: WO 2008/028839

(56) Entgegenhaltungen:
- EP-A- 1 398 434
- WO-A-2006/069633
- DE-A1- 10 212 794
- DE-B3-102004 038 569
- US-A1- 2003 031 025

## Beschreibung

Die Erfindung betrifft eine Handhabe, insbesondere einen Türgriff eines Kraftfahrzeuges, für ein schlüsselloses Zugangs- und Fahrberechtigungskontrollsystem, mit einem Gehäuse, das mit einem Hohlraum ausgeführt ist, in dem eine Elektronikeinheit angeordnet ist, die eine Leiterplatte aufweist, die mit mindestens einer als Sensor wirkenden Kommunikationsfläche, die elektrisch leitend ausgeführt ist, in Signalverbindung steht. Der Oberbegriff das Anspruchs 1 ist aus der DE 10 2004 038 569 B bekannt.

Bei Kraftfahrzeugen ist es bekannt, in Türgriffen Sensoren anzuordnen, um die Türöffnung zu bewirken. Insbesondere zum sogenannten "Keyless-Entry" trägt der Benutzer einen ID-Geber mit sich, der beispielsweise mittels eines elektromagnetischen Impulses, welcher vom Kraftfahrzeug ausgesandt wird, "aufgeweckt" wird. In einem solchen "aufgeweckten" Zustand kann der ID-Geber Identifikationssignale abgeben, die vom Kraftfahrzeug empfangen werden. Es kann eine Identifikation des ID-Gebers vorgenommen werden, ob dieser berechtigt ist, das Kraftfahrzeug zu öffnen. Hat der ID-Geber die erforderliche Berechtigung, so werden die Türschlösser des Kraftfahrzeuges in eine Öffnungsbereitschaftsstellung gebracht. Hierbei besitzt der Türgriff eine oder mehrere Sensorflächen. Nähert sich die Hand des Benutzers dieser Fläche, insbesondere der an der Griffinnenseite liegenden Sensorfläche an, so öffnet der Türverschluss. Der Griff kann des Weiteren noch weitere Sensoren aufweisen, beispielsweise in Form eines Tasters, durch dessen Betätigung das Kraftfahrzeug wieder verriegelt werden kann.

Bei den bekannten Türgriffen werden die die Sendeelektronik aufweisenden Bauteile in den Hohlraum der Handhabe eingelegt und dort vergossen. In der DE 102 21 511 A1 ist ein Türaußengriff eines Kraftfahrzeugs mit der genannten Sensorelektronik beschrieben. Sämtliche Sensoren innerhalb des Türaußengriffes arbeiten kapazitiv und verfügen jeweils über eine Elektrode, die zusammen mit einem Gegenstand, beispielsweise einer menschlichen Hand, einen jeweiligen Kondensator formen. Annäherungen und/oder Berührungen der menschlichen Hand bewirken Kapazitätsänderungen eines oder mehrerer dieser Kondensatoren, die mit Hilfe einer den Sensoren gemeinsamen Auswerteschaltung erfasst und in Bedienfunktionen umgesetzt werden. Hierbei ist es üblich, die Auswerteschaltung auf einer starren Leiterplatte - die auch als Leiterplatine bezeichnet werden kann - vorzusehen. Eine derartige Leiterplatine ist beispielsweise in der WO 03/071067 A1 offenbart. Es hat sich gezeigt, dass die genannten Leiterplatten in einigen Fällen der Form des Türgriffes gebogen werden müssen, um entsprechend im Hohlraum des Türgriffes eingelegt zu werden. Da es sich um ein sehr empfindliches Bauteil handelt, können Fehlfunktionen durch eine oben beschriebene Biegung hervorgerufen werden, so dass das schlüssellose Zugangs- und Fahrberechtigungskontrollsystem ausfallen kann.

Durch den Einsatz von dünnen, flexiblen Leiterplatten kann das oben genannte Problem gelöst werden. Derartige flexible Leiterplatten können in diverse Richtungen gefaltet werden, wodurch eine kompakte Bauform erzielt werden kann. In der DE 102 58 392 A1 ist beispielsweise ein Türgriff für eine Kraftfahrzeugtür mit einer Handhabe beschrieben, die eine flexible Leiterplatte aufweist, die von einem Trägerelement gehalten wird. Die flexible Leiterplatte umschlingt hierbei das Trägerelement. Ferner sind auf der flexiblen Leiterplatte Näherungssensoren für ein Keyless-Entry-System angeordnet. Nachteiligerweise sind derartige flexible Leiterplatten kostenintensiv, die mit den gesamten Elektronikbauteilen bestückt sind.

Der Erfindung liegt die Aufgabe zugrunde, eine Handhabe für ein schlüsselloses Zugangs- und/oder Fahrberechtigungskontrollsystem zu schaffen, welches die genannten Nachteile vermeidet, insbesondere eine Handhabe bereitgestellt wird, die einen einfachen Aufbau hat und eine zuverlässige Funktionsweise gewährleistet.

Zur Lösung dieser Aufgabe wird eine Handhabe mit den Merkmalen des Anspruches 1 vorgeschlagen. Vorteilhafte Ausführungsformen der erfindungsgemäßen Handhabe sind in den abhängigen Ansprüchen aufgeführt. In der nachfolgenden Beschreibung wird der Begriff Türgriff allgemein für eine Handhabe für ein bewegliches Element verwendet, wobei das bewegliche Element beispielsweise auch ein Handschuhfach, eine Heckklappe, ein Tankdeckel oder eine Fahrzeugtür sein kann.

Erfindungsgemäß ist vorgesehen, dass die Kommunikationsfläche als separates Bauteil in einem Abstand zur Leiterplatte angeordnet ist. Der Kern dieser Erfindung ist, dass die Auswerteelektronik auf der Leiterplatte angeordnet ist, wobei die als Sensor wirkende Kommunikationsfläche in der Handhabe separat zur Leiterplatte befestigt ist. Das bedeutet, dass eine Aufteilung beziehungsweise eine Trennung der Kommunikationsfläche, die vorzugsweise als Elektrode wirkt, und der Auswerteelektronik vorliegt, wodurch die Leiterplattenfläche minimiert werden kann und die Leiterplatte in jegliche Formen der Handhabe einsetzbar ist. Hierbei ist es denkbar, beispielsweise die Kommunikationsfläche im oder am Gehäuse anzuordnen. Es hat sich nachteiligerweise bei den im Stand der Technik bekannten Türgriffen gezeigt, dass bei einer Integration der Leiterplatte mit Sensoren Funktionsstörungen bei der Sensorik, insbesondere wenn die Sensoren im Biegebereich oder im Knickbereich der Leiterplatte angeordnet sind, entstehen können. Darüber hinaus sind derartige Leiterplatten - neben ihrer soeben beschriebenen Empfindlichkeit - kostenintensiv. Diese Nachteile werden durch die vorliegende Erfindung vermieden, bei der eine physikalische Trennung der Leiterplatte, auf der die Auswerteelektronik integriert ist, von den Sensoren vorgeschlagen wird.

Bei der Leiterplatte kann es sich beispielsweise um eine starre Leiterplatte handeln, die in dem Hohlraum der Handhabe eingelegt ist. Die starre Leiterplatte kann leicht gebogen sein, um beispielsweise in den Hohlraum zuverlässig zu passen. Da lediglich die Auswerteelektronik an der Leiterplatte angeordnet ist, können Störungen in der Sensorik nahezu vermieden werden.

In einer weiteren Ausführungsform der Erfindung kann die Leiterplatte eine flexible Leiterplatte sein, die beispielsweise eine flexible, biegeschlaffe Leiterfolie ist, die über ein geringes Gewicht verfügt und durch ihre flexible Bandstruktur eine geordnete Parallelführung von einer Vielzahl getrennter Leiterbahnen gestattet. Die flexible Leiterplatte kann beispielsweise ein flacher Folienleiter sein, bei dem die Leiterbahnen, ähnlich wie bei Flachbandkabeln, ausschließlich parallel in eine Richtung verlaufen. Dieser Folienleiter dient insbesondere für die elektrische Verbindung zwischen einer Vielzahl elektrischer Kontaktstellen. Des Weiteren kann die flexible Leiterplatte zusätzlich elektrische Schaltkreise aufweisen, die durch entsprechende Drucktechniken auf den flexiblen Leiterfolien abgebildet sind und eine zweidimensionale Struktur aufweisen. Auch bei dieser Ausgestaltungsform der Erfindung ist die Kommunikationsfläche von der an der flexiblen Leiterfolie angeordneten Auswerteelektronik räumlich getrennt.

In einer weiteren Möglichkeit ist die flexible Leiterplatte an einem Trägerelement gehalten. Hierbei ist es denkbar, beispielsweise das Trägerelement mit der Kommunikationsfläche auszuführen. In einer weiteren Alternative der Erfindung hat sich gezeigt, dass durch eine Anordnung der Kommunikationsfläche am Gehäuse eine exakte Positionierung dieser Flächen am Türgriff erzielt werden kann. In einer möglichen Ausführungsform der Erfindung kann die Kommunikationsfläche unmittelbar an der Innenwandung des Hohlraumes des Gehäuses angeordnet sein. Ferner kann die Kommunikationsfläche zumindest teilumfänglich am Gehäuse umspritzt sein.

Bei der Kommunikationsfläche kann es sich um eine Elektrode handeln, die in einer Ausführungsform ein großflächiges Edelstahlblech oder ein Metallblech, beispielsweise aus Kupfer ist. Je nach Anwendungsfall kann dieses Edelstahlblech form- und/oder kraftschlüssig an der Handhabe, insbesondere im Hohlraum des Gehäuses, befestigt sein.

Die Kommunikationsfläche kann in einer weiteren Ausführungsform durch eine entsprechende Dünnschichttechnologie auf der Innenwandung des Hohlraumes aufgetragen werden. Vorteilhafterweise wird die Kommunikationsfläche aufgedampft oder durch Sputtern auf der Innenwandung des Hohlraumes aufgetragen.

In einer möglichen Ausgestaltung der Handhabe ist die Kommunikationsfläche an der Außenfläche des Gehäuses vorgesehen. Beispielsweise kann die Kommunikationsfläche eine metallische Blende sein, die mit der Elektronikeinheit innerhalb der Handhabe in Signalverbindung steht.

Eine die Erfindung verbessernde Maßnahme sieht vor, dass die flexible Leiterplatte am Trägerelement aufliegt, das zumindest teilweise eine Profilstruktur aufweist, wobei die Leiterplatte der Profilstruktur bereichsweise angepasst ist. Durch geeignete, zusätzliche partielle Versteifungen der flexiblen Leiterplatte kann diese auch dreidimensionale Formen annehmen, die beinahe beliebig an die unterschiedlichsten Raumbedingungen anpassbar sind. Damit die Leiterplatte zuverlässig am Trägerelement positioniert ist, weist die Leiterplatte Bereiche auf, die beispielsweise in Ausnehmungen des Trägerelementes hineinragen, wodurch ein zuverlässiger Halt der Leiterplatte am Trägerelement erzielbar ist. Zusätzlich kann die Leiterplatte kraft- und/oder form- und/oder stoffschlüssig am Trägerelement befestigt werden.

Zweckmäßigerweise ist das Trägerelement in seiner äußeren Kontur gebogen und vorteilhafterweise der Form des Hohlraumes angepasst. Hierbei kann die flexible Leiterplatte auf einer Seite des Trägerelementes befestigt sein. Ebenfalls ist es denkbar, dass zumindest teilweise die flexible Leiterplatte das Trägerelement an mehreren Seiten umschlingt. Alternativ oder zusätzlich kann das Trägerelement ebenfalls die Kommunikationsfläche aufweisen. Die oben genannten Ausführungen, die diverse Möglichkeiten aufzeigen die Kommunikationsfläche am Gehäuse der Handhabe anzuordnen, sind selbstverständlich auf die Anordnung der Kommunikationsfläche am Trägerelement anwendbar, worauf hier - um Wiederholungen zu vermeiden - lediglich verwiesen wird.

Die metallische Kommunikationsfläche wirkt vorzugsweise als kapazitiver Sensor, wobei die Kommunikationsfläche gleichzeitig zur Abschirmung für die Elektronikeinheit in der Handhabe dienen kann. Mit Hilfe dieser Abschirmung können definierte elektrische Felder zur Verfügung gestellt werden, die für eine einwandfreie Sensorik und Funktionsweise sorgen.

Zur elektrischen Kontaktierung der Leiterplatte mit der Kommunikationsfläche sind unterschiedliche Verbindungsalternativen denkbar. In einer möglichen Ausführungsform der Handhabe weist die Leiterplatte mindestens einen flexiblen Leitungssteg auf, der beispielsweise als flacher Folienleiter ausgeführt sein kann, der mit der Kommunikationsfläche verbunden ist. Ebenfalls ist eine Verbindung beider Elemente durch ein Kabelelement möglich. Die tatsächliche physikalische Kontaktierung des Kabels mit der Kommunikationsfläche sowie der Leiterplatte kann beispielsweise über einen Federkontakt, einen Steckkontakt, einer Crimpverbindung oder durch eine adhäsive Schraubenverbindung erfolgen. Vorteilhafterweise kann ein leitfähiger Klebstoff Verwendung finden, der metallische Füllstoffe aufweist. Das Basismaterial des leitfähigen Klebstoffes ist ein Kunstharz, das mit entsprechenden metallischen oder anorganischen Füllstoffen gefüllt ist. Epoxide, Polymide oder Silikone können als Basisharz hierfür eingesetzt werden. Durch das Einbringen geeigneter Füllstoffe werden die Eigenschaften des nicht leitenden Basisharzes wesentlich verändert. Als metallische Füllstoffe sind beispielsweise Palladium, Gold, Silber, Kupfer, Nickel und/oder Graphit denkbar, wobei mit steigendem Füllgrad die Leitfähigkeit sich erhöht. Bei dem leitfähigen Kunststoff handelt es sich vorzugsweise um einen Silberleitkleber.

Die elektrische Verbindung zwischen der Leiterplatte und der Kommunikationsfläche kann ferner durch an der Leiterplatte sowie an der Kommunikationsfläche vorgesehene Lötflächen erfolgen, an denen das Kabelelement durch Löten befestigt wird.

Ebenfalls können die Kommunikationsfläche und die Leiterplatte über einen dünnen Metalldraht durch Bondtechnologie verbunden sein. Je nach Anwendungsfall kann beispielsweise das Thermosonicbonden oder das Ultrasonicbonden zum Einsatz kommen.

Die elektrische Verbindung zwischen der Kommunikationsfläche und der Leiterplatte kann in einer weiteren Ausführungsform der Erfindung durch einen leitfähigen Kunststoff erzielt werden. Hierbei kann der elektrisch leitende Kunststoff ein gefüllter leitender Kunststoff sein, in dem ein leitender Füllstoff wie beispielsweise Ruß oder Kaminruß, Kohlenstofffaser oder Metallpulver zu einem wärmehärtenden oder thermoplastischen Harz gegeben wird. Alternativ dazu können auch selbstleitende Kunststoffe zum Einsatz kommen, die auf Polymeren basieren können, die durch Oxidation, Reduktion oder Protonierung (Dotierung) elektrisch leitend gemacht werden. Denkbar ist, dass beispielsweise zumindest bereichsweise das Trägerelement aus einem leitenden Kunststoff besteht, wodurch eine elektrische Verbindung zwischen der flexiblen Leiterplatte und der auf dem Trägerelement sich befindenden Kommunikationsfläche erzielbar ist. Ebenfalls kann in einer vorteilhaften Ausführungsform die Kommunikationsfläche selbst als dünne Folie oder ein leitender Kunststoff sein, die entsprechend den oben aufgeführten Ausführungen in der Handhabe, insbesondere am Gehäuse und/oder am Trägerelement angeordnet sind.

Die Verbindung der Kommunikationsfläche mit der Leiterplatte kann in einer weiteren Möglichkeit der Erfindung durch eine kapazitive Kopplung erfolgen.

In einer vorteilhaften Ausführungsform der Erfindung sind das Trägerelement und/oder die Leiterplatte durch einen Hüllkörper umgeben, wodurch eine vorkonfektionierte Moduleinheit entsteht. Die Kommunikationsfläche kann innerhalb der Moduleinheit sich befinden. Einer der Vorteile dieser Ausgestaltung ist, dass eine Funktionsüberprüfung der vormontierten Moduleinheit vorgenommen werden kann, bevor die Moduleinheit in die Handhabe positioniert und befestigt wird. Beispielsweise können aus der Moduleinheit Kabelelemente herausragen, um eine elektrische Verbindung der Leiterplatte mit den relevanten, außerhalb der Moduleinheit angeordneten Bauelementen - wie Kommunikationsfläche, Steuereinheit der Fahrzeugelektronik etc. - erzielen zu können. Ein weiterer Vorteil dieses Hüllkörpers ist, dass die elektronischen Schaltkreise auf der Leiterplatte während der Montage zuverlässig geschützt werden.

Ist das Trägerelement mit der Leiterplatte innerhalb des Hohlraumes eingelegt, wird der Hohlraum vergossen. Zweckmäßigerweise ist das Gehäuse mehrschalig aufgebaut, wobei in einer Unterschale die Elektronikeinheit innerhalb des Hohlraumes vergossen wird. Anschließend wird eine Oberschale auf die Unterschale aufgesetzt, wodurch im zusammengesetzten Zustand beider Schalen der Türgriff sich bildet und der Hohlraum mit der Vergussmasse vollständig durch die Oberschale geschlossen ist. Beide Schalen werden beispielsweise durch ein Verclipsen oder Verschrauben miteinander befestigt.

Weitere Merkmale und Einzelheiten der Erfindung ergeben sich aus der nachfolgenden Beschreibung, in der unter Bezugnahme auf die Zeichnungen mehrere Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen:
- Fig. 1: einen Türgriff entsprechend der Erfindung mit seinen Einzelheiten,
- Fig. 2: eine weitere Ausführungsform des Türgriffes,
- Fig. 3: eine Anordnung der flexiblen Leiterplatte am Trägerelement,
- Fig. 4: eine schematische Anordnung der flexiblen Leiterplatte am Trägerelement,
- Fig. 5: eine weitere Alternative des Türgriffes,
- Fig. 6a: eine mögliche Kontaktierungsalternative zur elektrischen Verbindung von Leiterplatte und Kommunikationsfläche,
- Fig. 6b: eine weitere Kontaktierungsalternative zur elektrischen Verbindung von Leiterplatte und Kommunikationsfläche,
- Fig. 6c: eine weitere Ausführungsform einer Kontaktierungsalternative zur elektrischen Verbindung von Leiterplatte und Kommunikationsfläche,
- Fig. 6d: eine weitere Alternative einer elektrischen Kontaktierung,
- Fig. 7a: eine Kontaktierungsmöglichkeit über eine Crimp-Verbindung, wobei die Crimp-Verbindung sich im geöffneten Zustand befindet,
- Fig. 7b: die Crimp-Verbindung gemäß Fig. 7a, wobei die Crimp-Verbindung sich im geschlossenen Zustand befindet,
- Fig. 8: eine Schnittansicht der flexiblen Leiterplatte und
- Fig. 9: eine weitere Alternative der Leiterplatte in Schnittansicht.

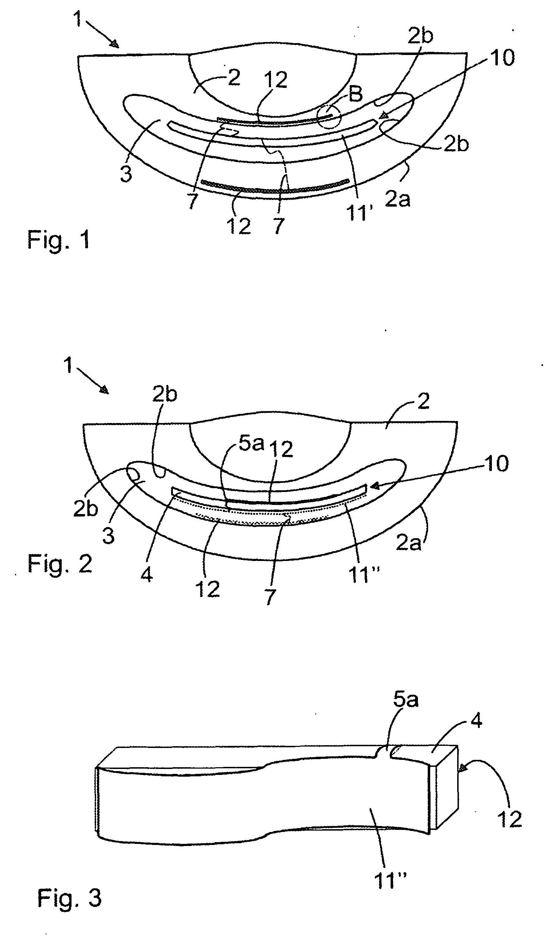

Fig. 1 zeigt einen Türgriff 1 für ein schlüsselloses Zugangs- und Fahrberechtigungskontrollsystem. Der Türgriff 1 weist ein Gehäuse 2 auf, das ein Spritzgussteil aus Kunststoff ist. Innerhalb des Gehäuses 2 ist eine Elektronikeinheit 10 angeordnet, die eine Annäherung einer Person bzw. eine Berührung des Türgriffes 1 durch die Person erfasst. Die Elektronikeinheit 10 weist hierbei eine starre Leiterplatte 11' auf, die mit einer entsprechenden Auswerteelektronik bestückt ist. Diese Auswerteelektronik kann beispielsweise einen Mikrocontroller, Kondensatoren, Widerstände, Spulen ect. aufweisen, die in den Figuren explizit nicht dargestellt sind. Gemäß Fig. 1 erkennt man, dass die Leiterplatte 11' mit einer Kommunikationsfläche 12 in Signalverbindung steht, die an der der Fahrzeugtür zugewandten Seite des Türgriffgehäuses 2 sich befindet. Die Kommunikationsfläche 12 dient zur Realisierung eines kapazitiven Näherungssensors im Rahmen eines schlüssellosen Zugangs- und Fahrberechtigungskontrollsystems. Sobald sich eine berechtigte Person der Kommunikationsfläche 12 nähert, ermöglicht die als Sensor wirkende Kommunikationsfläche 12 den Zugang zum Kraftfahrzeug ohne Benutzung eines elektronischen oder mechanischen Schlüssels. Denn die betreffende Person wird von der Kommunikationsfläche 12 sensiert, so dass ein Frage-Antwort-Dialog zwischen einer kraftfahrzeugseitigen Steuer-/ Auswerteelektronik und einem von der Person mitgeführten Transponder stattfindet. Nach erfolgreichem Frage-Antwort-Dialog werden die einzelnen nicht dargestellten Kraftfahrzeugtürschlösser entriegelt. Das ist bekannt, wozu im Einzelnen beispielsweise auf die DE 10 2006 008 144 verwiesen sei.

Des Weiteren ist eine weitere Kommunikationsfläche 12 an der Handhabe 1 vorgesehen, die an der der Tür abgewandten Seite der Handhabe 1 angeordnet ist. Diese Kommunikationsfläche 12, die im vorliegenden Ausführungsbeispiel als Berührungssensor dient, kann zusätzlich zu der ersten Kommunikationsfläche 12, die der Fahrzeugtür zugewandt ist, vorgesehen sein. Im Rahmen des in Fig. 1 dargestellten Ausführungsbeispiels sorgen solche Kontaktierungen im Bereich des Berührungssensors dafür, dass die angesprochene Kraftfahrzeugtür wieder verriegelt wird. Im vorliegenden Ausführungsbeispiel ist die starre Leiterplatte 11' leicht gebogen und innerhalb des Hohlraumes 3 des Gehäuses 2 eingelegt. Die Kommunikationsflächen 12 sind elektrisch leitend ausgeführt und jeweils über ein Kabelelement 7 mit der Leiterplatte 11' verbunden. Bei den Kommunikationsflächen 12 handelt es sich um großflächige Metallbleche, die innerhalb des Gehäuses 2 umspritzt sind. Während des Montageprozesses ragen hierbei die Kabelelemente 7, die mit der umspritzten Kommunikationsfläche 12 verbunden sind, aus dem Gehäuse 2 in den Hohlraum 3 heraus. Die Kabelelemente 7 werden mit der Leiterplatte 11' anschließend kontaktiert bzw. verbunden, welches im Folgenden noch detailliert beschrieben wird, wobei im letzten Schritt der Hohlraum 3 mit der Elektronikeinheit 10 mit einer entsprechenden Vergussmasse vergossen wird.

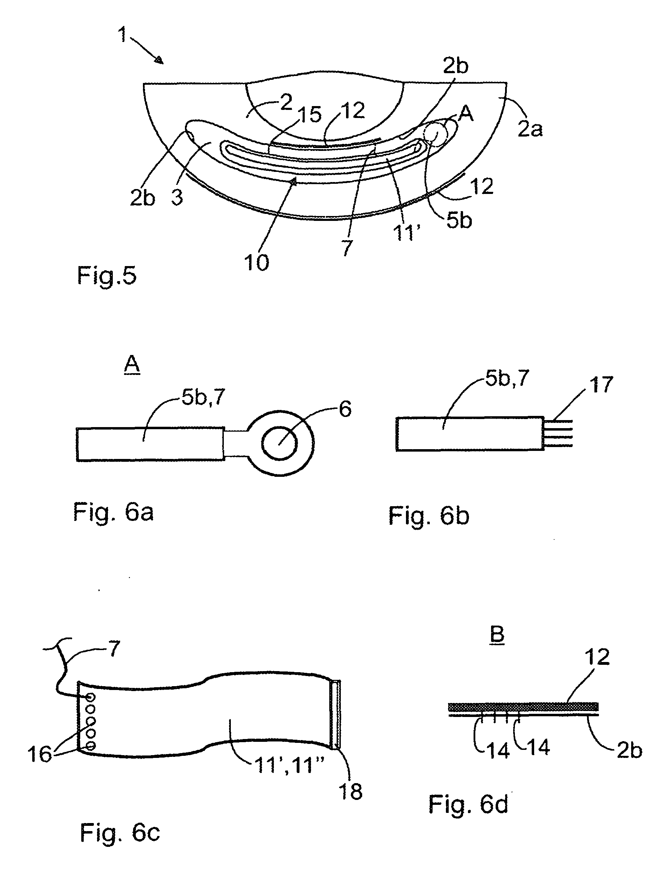

Alternativ kann die Kommunikationsfläche 12 mit Kontaktpins 14 ausgeführt sein, die aus der Innenwandung 2b des Gehäuses 2 herausragen, welches in Fig. 6d dargestellt ist. Über die Kontaktpins 14 kann eine Verbindung beispielsweise über ein Kabelelement 7 zur am Trägerelement 4 angeordneten Leiterplatte 11' hergestellt werden.

Fig. 2 zeigt weitere Alternativen in Bezug auf die Anordnung der Kommunikationsfläche 12. Hierbei ist die Leiterplatte 11" als flexible Leiterfolie ausgeführt, die an einem Trägerelement 4 anliegt. Zum einen kann die Kommunikationsfläche 12 unmittelbar am Trägerelement 4 angeordnet sein. Hierbei ist die Kommunikationsfläche 12 an der der flexiblen Leiterplatte 11" abgewandten Seite des Trägerelementes 4 angeordnet. Die Verbindung zwischen der flexiblen Leiterplatte 11" und der Kommunikationsfläche 12 kann beispielsweise über einen flexiblen Leitungssteg 5a erfolgen, welches in schematischer Darstellung in Fig. 3 gezeigt ist. Alternativ oder zusätzlich kann eine weitere Kommunikationsfläche 12 an der Innenwandung 2b des Hohlraumes 3 vorgesehen sein, die in Fig. 2 aufgedampft oder lackiert mit einem Leitlack sein kann und der Fahrzeugtür abgewandt ist.

Die Kontaktierungsverbindungen zwischen der Kommunikationsfläche 12 und der starren/flexiblen Leiterplatte 11',11" können verschiedenfältig sein. Beispielsweise kann die Leiterplatte 11',11" oder die Kommunikationsfläche 12 Lötöffnungen 16 aufweisen, an der ein Kabelelement 4 an einem Ende angelötet ist, welches in Fig. 6c bezogen auf die Leiterplatte 11',11" dargestellt ist. Das andere Ende des Kabelelementes 7 ist mit der Kommunikationsfläche 12 verbunden. Alternativ kann die Leiterplatte 11',11" ein Steckerelement 18 aufweisen, an den ein Kabelelement 7 zur Verbindung mit der Kommunikationsfläche 12 einsteckbar ist, welches ebenfalls in Fig. 6c angedeutet ist.

Das Kabelelement 7 kann in einer weiteren Ausführungsform, die in Fig. 6b dargestellt ist, Kontaktpins 17 aufweisen, die an die flexible Leiterplatte 11" oder an die Kommunikationsfläche 12 an entsprechenden Stellen anlötbar sind.

Alternativ kann eine Verbindung zwischen der Kommunikationsfläche 12 und der Leiterplatte 11',11" über eine Crimp-Verbindung erfolgen. Vorzugsweise sind die Kabelenden mit Crimp-Kontakten versehen, die anschließend in einem Stecker verbaut (umspritzt oder gesteckt) werden. In einem dazugehörigen Gegenstecker werden die passenden Gegenkontakte verbaut. Die Leiterplatte kann flexibel oder starr ausgeführt sein.

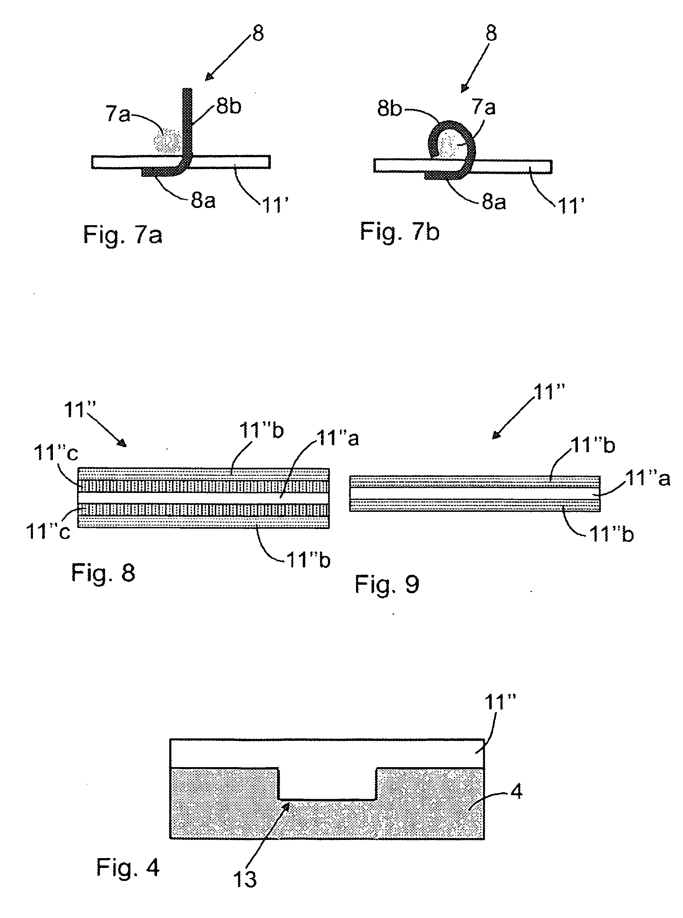

In Fig. 7a und 7b ist eine weitere mögliche Crimp-Verbindung dargestellt, die sich durch ihre einfache Montage auszeichnet. Das Crimpelement 8, das an der starren Leiterplatte 11' befestigt ist, weist ein Bodenelement 8a und ein Halteelement 8b auf. Die Kabelseele 7a des Kabelelementes 7 ist durch das in Richtung der Leiterplatte 11' gebogene Halteelement 8b gehalten, welches in Fig. 7b angedeutet ist. Gleichzeitig besteht ein elektrischer Kontakt zwischen einem Leiterzug der Leiterplatte 11' und der Kabelseele 7a.

Das verwendete Crimpelement 8 durchdringt die Leiterplatte 11', wobei das Halteelement 8b die Kabelseele 7a an der Oberseite der Leiterplatte 11' hält und gleichzeitig das Bodenelement 8a an der Unterseite der Leiterplatte 11' anliegt. Das Grundmaterial eines solchen Crimpelementes 8 bestehen beispielsweise aus CuSn4, CuFe, CuNiSi oder CuCrTiSi und die Oberfläche des Crimpelementes 8 kann beispielsweise eine aus Sn, Au oder Ag bestehende Beschichtung aufweisen (geringer Übergangswiderstand in der Kontaktzone). Beim Befestigungsvorgang des Kabelelementes 7 an der Leiterplatte 11' wird zunächst die Kabelseele 7a an das Crimpelement 8 angelegt, welches in Fig. 7a dargestellt ist. Anschließend wird das Haltelement 8b des Crimpelementes 8 in Richtung der Leiterplatte 11' gebogen bis zuverlässig die Kabelseele 7a des Kabelelementes 7 durch das Halteelement 8b kraftschlüssig an der Leiterplatte 11' gehalten ist. Alternativ kann die Leiterplatte flexibel als Leiterfolie ausgeführt sein, welches explizit nicht dargestellt ist.

In Fig. 4 ist eine weitere Möglichkeit dargestellt, einen zuverlässigen Halt einer flexiblen Leiterplatte 11" am Trägerelement 4 zu erreichen. Hierbei weist das Trägerelement 4 eine Art Profilstruktur auf, die durch eine rechteckförmige Einbuchtung 13 ausgebildet ist. Die Einbuchtung 13 kann auch weitere geometrische Formen aufweisen, beispielsweise schwalbenschwanzartig. In diese Einbuchtung 13 ragt vorsprungartig die Leiterplatte 11" mit einem Bereich hinein. Durch derartige einfache Maßnahmen kann ein zufriedenstellender Sitz der Leiterplatte 11" am Trägerelement 4 sichergestellt werden. Alternativ oder zusätzlich kann die Leiterplatte 11" Befestigungselemente aufweisen, wodurch eine zuverlässige Fixierung der Leiterplatte 11" am Trägerelement 4 erfolgen kann.

Um eine einfache Montage der Elektronikeinheit 10 in die Handhabe 1 zu erzielen, kann die starre Leiterplatte 11' durch einen Hüllkörper 15 umgeben sein, welches in Fig. 5 exemplarisch dargestellt ist. Im vormontierten Zustand wird diese Moduleinheit in den Hohlraum 3 des Gehäuses 2 eingeführt und anschließend mit einer Vergussmasse vergossen. Neben einer Kommunikationsfläche 12, die an der der Tür zugewandten Seite des Türgriffes 1 angeordnet ist, kann der Türgriff 1 an der Außenfläche 2a des Gehäuses 2 eine Kommunikationsfläche 12 aufweisen. Diese außenliegende Kommunikationsfläche 12 kann beispielsweise aufgedampft sein oder eine aufsetzbare Metallblende sein, die über eine Schraubenverbindung am Türgriff 1 befestigt ist. Der Kontakt zwischen der Metallblende 12 und der Leiterplatte 11' erfolgt über einen flexiblen Leitungssteg 5b, der an seinem freien Ende eine Öffnung 6 aufweist, welches schematisch in Fig. 6a dargestellt ist. Im vorliegenden Ausführungsbeispiel ist das Gehäuse 2 mehrschalig ausgeführt, wobei die außenliegende Kommunikationsfläche 12 eine metallische Schale für das Gehäuse 2 darstellt, die über eine durch die Öffnung 6 ragende, nicht dargestellte Schraube am Türgriff 1 befestigt ist, wodurch eine elektrische Verbindung zwischen der Leiterplatte 11' und der außenliegenden Kommunikationsfläche 12 entsteht. Anstelle einer starren Leiterplatte kann eine auf einem Trägerelement, aufliegende, flexible Leiterplatte, eingesetzt werden, die durch einen oben beschriebenen Hüllkörper umgeben ist, der im Hohlraum 3 der Handhabe 1 eingesetzt ist.

Bei den in den Figuren dargestellten Leiterplatten 11',11" kann es sich um ein- oder doppelseitige oder auch um mehrlagige Leiterplatten 11',11" handeln. In Fig. 9 ist exemplarisch eine flexible Leiterplatte 11" dargestellt, die vorrangig aus Polyimid 11"a besteht, das als Trägermaterial dient. Oberhalb und unterhalb des Trägermaterials 11 "a befindet sich die Leiterbahn 11"b der Leiterplatte 11 ", die eine Kupferfolie ist. Die in Fig. 9 dargestellte flexible Leiterplatte 11" ist kleblos. Im Gegensatz dazu können auch flexible Leiterplatten 11" mit Kleber hinsichtlich der vorliegenden Erfindung zum Einsatz kommen, bei der zwischen der Kupferfolie 11"b als metallischer Leiter und dem Trägermaterial 11"a ein Kleber 11"c als Haftmittel vorgesehen ist, welches schematisch in Fig. 8 gezeigt ist.

### Bezugszeichenliste

- 1: Handhabe, Türgriff
- 2: Gehäuse
- 2a: Außenfläche des Gehäuses
- 2b: Innenwandung
- 3: Hohlraum
- 4: Trägerelement
- 5a: Leitungssteg
- 5b: Leitungssteg
- 6: Öffnung
- 7: Kabelelement
- 7a: Kabelseele
- 8: Crimpelement
- 8a: Bodenelement
- 8b: Halteelement
- 10: Elektronikeinheit
- 11': starre Leiterplatte
- 11": flexible Leiterplatte, Leiterfolie
- 11"a: Trägermaterial
- 11"b: Kupferfolie, Leiterzug
- 11"c: Kleber
- 12: Kommunikationsfläche
- 13: Einbuchtung
- 14: Kontaktpins der Kommunikationsfläche
- 15: Hüllkörper
- 16: Lötöffnung
- 17: Kontaktpins des Kabelelementes
- 18: Steckerelement

## Patentansprüche

1. Handhabe (1), Insbesondere Türgriff eines Kraftfahrzeuges, für ein schlüsselloses Zugangs- und Fahrberechtigungskantrollsystem, mit einem Gehäuse (2), das mit einem Hohlraum (3) ausgeführt ist, in dem eine Elektronikeinheit (10) angeordnet ist, die eine Leiterplatte (11',11") aufweist, die mit mindestens einer als Sensor wirkenden Kommunikationfläche (12), die elektrisch leitend ausgeführt ist, in Signalverbindung steht, wobei das Gehäuse (2) ein Spritzgusatell aus Kunststoff ist
**dadurch gekennzeichnet,**
**dass** die Kommunikationsfläche (12) als separates Bauteil in einem Abstand zur Leiterplatte (11',11") angeordnet ist,
wobei die Kommunikationsfläche (12) als kapazitiver Sensor wirkt und die Kommunikationsfläche (12) zumindest teilumfänglich umspritzt ist.

2. Handhabe (1) nach Anspruch 1,
**dadurch gekennzeichnet,**
**dass** die leiterplatte (11') starr ausgebildet ist.

3. Handhabe (1) nach Anspruch 1 oder 2,
**dadurch gekennzeichnet,**
**dass** der Hohlraum (3) eine innenwandung (2b) aufweist, an der die Kommunikationsfläche (12) angeordnet ist.

4. Handhabe (1) nach Anspruch 1 oder 3,
**dadurch gekennzeichnet,**
**dass** die Leiterplatte (11 ") flexibel ausgeführt ist, wobei Insbesondere die Leiterplatte (11") an einem Trägerelement (4) gehalten ist.

5. Handhabe (1) nach Anspruch 4,
**dadurch gekennzeichnet,**
**dass** die Kommunikationsfläche (12) an der der Leiterplatten (11") abgewandten Seite des Trägerelementes (4) angeordnet ist

6. Handhabe (1) nach einem der vorhergehenden Ansprüche,
**dadurch gekennzeichnet,**
**dass** die Leiterplatte (11") am Trägerelement (4) aufliegt, das zumindest teilweise eine Profilstruktur aufweist, wobei die Leiterplatten (11") der Profilatruktur bereichsweise angepasst ist.

7. Handhabe (1) nach einem der vorhergehenden Ansprüche,
**dadurch gekennzeichnet,**
**dass** das Trägerelement (4) der Form des Hohlraumes (3) angepaast ist.

8. Handhabe (1) nach einem der vorhergehenden Ansprüche,
**dadurch gekennzeichnet,**
**dass** die Kommunikationsfläche (12) an der Außenfläche (2a) des Gehäuses (2) angeordnet ist.

9. Handhabe (1) nach einem der vorhergehenden Ansprüche,
**dadurch gekennzeichnet,**
**dass** die Leiterplatte (11',11") mindestens einen flexiblen Leitungssteg (5a,5b) aufweist, der mit der Kommunikationsfläche (12) verbunden ist, wobei insbesondere der Leitungssteg (5b) an seinem freien Ende eine Öffnung (8) aufweist, das Gehäuse (2) mehrschalig ausgeführt ist und eine metallische Schale aufweist, die über eine durch die Öffnung (8) ragende Schraube an der Handhabe (1) befestigt ist, wodurch eine elektrische Verbindung zwischen der Leiterplatte (11',11") und der Kommunikationsfläche (12) entsteht.

10. Handhabe (1) nach einem der vorhergehenden Ansprüche,
**dadurch gekennzeichnet,**
**dass** über ein Kabelelement (7) die Verbindung zwischen der Kommunikationfläche (12) und der Leiterplatten (11',11") besteht.

11. Handhabe (1) nach einem der vorhergehenden Ansprüche,
**dadurch gekennzeichnet,**
**dass** die Verbindung zwischen der Kommunikationsfläche (12) und der Leiterplatte (11',11") Ober ein Crimpelement (8) besteht, insbesondere das Crimpelement (8), das an der Leiterplatte (11',11") befestigt ist, ein Bodenalement (8a) und ein Halteelement (8b) aufweist, und die Kabelseele (7a) des Kabelelementes (7) durch das in Richtung der Leiterplatte (11',11") gebogene Halteelement (8b) gehalten ist, wobei gleichzeitig ein elektrischer Kontakt zwischen einem Leiterzug der Leiterplatte (11', 11") und der Kabelseele (7a) besteht.

12. Handhabe (1) nach Anspruch 10 oder 11,
**dadurch gekennzeichnet,**
**dass** das Crimpelement (8) die Leiterplatte (11',11") durchdringt und das Halteelement (8b) die Kabelseele (7a) an der Oberseite der Leiterplatte (11',11") hält, wobei das Bodenelemant (8a) an der Unterseite der Leiterplatte (11',11") anliegt.

13. Handhabe (1) nach einem der vorhergehenden Ansprüche,
**dadurch gekennzeichnet,**
**dass** die Leiterplatte (11',1l") eine Letfläche, Insbesondere eine Lötoffnung (16) aufweist, an der das Kabelelement (7) stoffschlüssig befestigt ist.

14. Handhabe (1) nach einem der vorhergehenden Ansprüche,
**dadurch gekennzeichnet,**
**dass** die Kommunikationsfläche (12) und die Leiterplatte (11',11") über einen dünnen Metalldraht verbandet sind.

15. Handhabe (1) nach einem der vorhergehenden Ansprüche,
**dadurch gekennzeichnet,**
**dass** die Kommunikationsfläche (12) und die Leiterplatte (11',11") mit einem leitfähigen Klebstoff, der metallische Füllstoffe aufweist, verklebt sind oder über einen Federkontakt, einen Steckkontakt oder über einen leitfähigen Kunststoff verbunden sind.

16. Handhabe (1) nach einem der vorhergehenden Ansprüche,
**dadurch gekennzeichnet,**
**dass** das Trägerelement (4) und/oder die Leiterplatte (11',11") durch einen Hullkörper (15) umgeben sind, wodurch eine vorkonfektionierte Moduleinheit - entsteht.

17. Handhabe (1) nach einem der vorhergehenden Ansprüche,
**dadurch gekennzeichnet,**
**dass** das Kabelelement (7) der umspritzten Kormmunikationsfläche (12) herausragt, insbesondere die umspritzt Kommunikationfläche (12) Kontaktpins (14) zur Verbindung mit der Leiterplatte (11',11") aufweist, die aus der Innenwandung (2b) des Gehäuse (2) herausragen.

18. Handhabe (1) nach einem der vorhergehenden Ansprüche,
**dadurch gekennzeichnet,**
**dass** die Kommunikationsfläche (12) ein Metallblech ist oder dass die Kommunikationsfläche (12) eine dünne Metallbeschichtung ist.

19. Handhabe (1) nach einem der vorhergehenden Ansprüche,
**dadurch gekennzeichnet,**
**dass** die Kommunikationsfläche (12) am Trägerelement (4) angeordnet ist.

20. Handhabe (1) nach einem der vorhergehenden Ansprüche,
**dadurch gekennzeichnet,**
**dass** die Leiterplatte (11") Befestigungselemente aufweist, wodurch die Leiterplatte (11") am Trägerelement (4) lösbar gehalten Ist.

21. Handhabe (1) nach einem der vorhergehenden Ansprüche,
**dadurch gekennzeichnet,**
**dass** die Leiterplatte (11',11") im Hohlraum (3), insbesondere mit dem Trägerelement (4) und/oder mit der Kommunikationsfläche (12) vergossen ist.

## Claims

1. A handle (1), in particular a door handle of a motor vehicle, for a keyless access and driving authorization control system, with a casing (2) which is designed with a cavity (3) in which is arranged an electronic unit (10) which has a printed circuit board (11', 11") which is connected by signals to at least one communication area (12) which acts as a sensor and which is made electrically conductive, wherein the casing (2) is an injection-moulded part of plastics material, **characterized in that** the communication area (12) is arranged as a separate component at a distance from the printed circuit board (11', 11 "), wherein the communication area (12) acts as a capacitive sensor, and the communication area (12) has injection moulding around it at least over part of its periphery.

2. A handle (1) according to Claim 1, **characterized in that** the printed circuit board (11') is made rigid.

3. A handle (1) according to Claim 1 or 2, **characterized in that** the cavity (3) has an inner wall (2b) on which the communication area (12) is arranged.

4. A handle (1) according to Claim 1 or 3, **characterized in that** the printed circuit board (11") is made flexible, wherein in particular the printed circuit board (11") is held on a carrier element (4).

5. A handle (1) according to Claim 4, **characterized in that** the communication area (12) is arranged on the side of the carrier element (4) facing away from the printed circuit board (11 ").

6. A handle (1) according to any one of the preceding Claims, **characterized in that** the printed circuit board (11") rests on the carrier element (4), which has at least in part a profiled structure, wherein the printed circuit board (11 ") is adapted locally to the profiled structure.

7. A handle (1) according to any one of the preceding Claims, **characterized in that** the carrier element (4) is adapted to the shape of the cavity (3).

8. A handle (1) according to any one of the preceding Claims, **characterized in that** the communication area (12) is arranged on the outer face (2a) of the casing (2).

9. A handle (1) according to any one of the preceding Claims, **characterized in that** the printed circuit board (11', 11") has at least one flexible connector web (5a, 5b) which is connected to the communication area (12), wherein in particular the connector web (5b) has an opening (6) at its free end, the casing (2) is constructed with a multiplicity of layers and has a metallic layer which is fastened to the handle (1) by way of a screw projecting through the opening (6), as a result of which an electrical connection is formed between the printed circuit board (11', 11") and the communication area (12).

10. A handle (1) according to any one of the preceding Claims, **characterized in that** the connection between the communication area (12) and the printed circuit board (11', 11") is made by way of a cable element (7).

11. A handle (1) according to any one of the preceding Claims, **characterized in that** the connection between the communication area (12) and the printed circuit board (11', 11") is made by way of a crimped element (8), in particular the crimped element (8) which is fastened to the printed circuit board (11', 11") and has a base element (8a) and a holding element (8b), and the core (7a) of the cable element (7) is held by the holding element (8b) which is curved in the direction of the printed circuit board (11', 11 "), wherein an electrical contact occurs at the same time between a conductor track of the printed circuit board (11', 11 ") and the cable core (7a).

12. A handle (1) according to Claim 10 or 11, **characterized in that** the crimped element (8) passes through the printed circuit board (11', 11"), and the holding element (8b) holds the cable core (7a) on the upper side of the printed circuit board (11', 11"), wherein the base element (8a) rests against the underside of the printed circuit board (11', 11").

13. A handle (1) according to any one of the preceding Claims, **characterized in that** the printed circuit board (11', 11") has a solder area, in particular a solder opening, (16) to which the cable element (7) is fastened in an integral manner.

14. A handle (1) according to any one of the preceding Claims, **characterized in that** the communication area (12) and the printed circuit board (11', 11") are connected by way of a thin metallic wire.

15. A handle (1) according to any one of the preceding Claims, **characterized in that** the communication area (12) and the printed circuit board (11', 11") are glued by a conductive adhesive which has metallic fillers, or are connected by way of a spring contact, a plug-in contact or by way of a conductive plastics material.

16. A handle (1) according to any one of the preceding Claims, **characterized in that** the carrier element (4) and/or the printed circuit board (11', 11") are surrounded by an enveloping body (15), as a result of which a pre-fabricated module unit is produced.

17. A handle (1) according to any one of the preceding Claims, **characterized in that** the cable element (7) projects from the communication area (12) with injection moulding around it, in particular the communication area (12) with injection moulding around it has contact pins (14) for connection to the printed circuit board (11', 11 ") which project out of the inner wall (2b) of the casing (2).

18. A handle (1) according to any one of the preceding Claims, **characterized in that** the communication area (12) is a metallic sheet, or the communication area (12) is a thin metallic coating.

19. A handle (1) according to any one of the preceding Claims, **characterized in that** the communication area (12) is arranged on the carrier element (4).

20. A handle (1) according to any one of the preceding Claims, **characterized in that** the printed circuit board (11') has fastening elements, as a result of which the printed circuit board (11') is held in a detachable manner.

21. A handle (1) according to any one of the preceding Claims, **characterized in that** the printed circuit board (11', 11") is cast in the cavity (3), in particular with the carrier element (4) and/or with the communication area (12).

## Revendications

1. Manette (1), en particulier poignée de porte d'un véhicule automobile, pour un système de contrôle d'autorisation d'accès et de roulement sans clé, comprenant un boîtier (2) réalisé avec un espace creux (3) renfermant une unité électronique (10) qui présente une plaquette de circuits imprimés (11', 11 ") en liaison par signal avec au moins une surface de communication (12) agissant comme capteur et réalisée de manière électroconductrice, sachant que le boîtier (2) est une pièce moulée par injection en plastique, **caractérisée en ce que** la surface de communication (12) est disposée comme un composant ou élément séparé à distance de la plaquette de circuits imprimés (11', 11"), sachant que la surface de communication (12) agit comme un capteur capacitif et la surface de communication (12) est surmoulée au moins partiellement sur sa périphérie.

2. Manette (1) selon la revendication 1, **caractérisée en ce que** la plaquette de circuits imprimés (11') est réalisée de manière rigide.

3. Manette (1) selon la revendication 1 ou 2, **caractérisée en ce que** l'espace creux (3) présente une paroi intérieure (2b), sur laquelle est disposée la surface de communication (12).

4. Manette (1) selon la revendication 1 ou 3, **caractérisée en ce que** la plaquette de circuits imprimés (11") est réalisée de manière flexible, sachant que la plaquette de circuits imprimés (11") est maintenue en particulier sur un élément support (4).

5. Manette (1) selon la revendication 4, **caractérisée en ce que** la surface de communication (12) est disposée sur le côté éloigné de la plaquette de circuits imprimés (11 ") de l'élément support (4).

6. Manette (1) selon l'une quelconque des revendications précédentes, **caractérisée en ce que** la plaquette de circuits imprimés (11') repose sur l'élément support (4) qui présente au moins en partie une structure profilée, sachant que la plaquette de circuits imprimés (11") est adaptée par endroits à la structure profilée.

7. Manette (1) selon l'une quelconque des revendications précédentes, **caractérisée en ce que** l'élément support (4) est adapté à la forme de l'espace creux (3).

8. Manette (1) selon l'une quelconque des revendications précédentes, **caractérisée en ce que** la surface de communication (12) est disposée sur la surface extérieure (2a) du boîtier (2).

9. Manette (1) selon l'une quelconque des revendications précédentes, **caractérisée en ce que** la plaquette de circuits imprimés (11', 11 ") présente au moins une barrette conductrice flexible (5a, 5b) qui est reliée à la surface de communication (12), sachant qu'en particulier la barrette conductrice (5b) présente une ouverture (6) sur son extrémité libre, le boîtier (2) est réalisé à plusieurs coques et présente une coque métallique qui est fixée par une vis traversant l'ouverture (6) sur la manette (1), ce qui provoque une liaison électrique entre la plaquette de circuits imprimés (11', 11") et la surface de communication (12).

10. Manette (1) selon l'une quelconque des revendications précédentes, **caractérisée en ce que** la liaison entre la surface de communication (12) et la plaquette de circuits imprimés (11', 11 ") est établie par un élément câblé (7).

11. Manette (1) selon l'une quelconque des revendications précédentes, **caractérisée en ce que** la liaison entre la surface de communication (12) et la plaquette de circuits imprimés (11', 11") est établie par un élément de sertissage (8), en particulier l'élément de sertissage (8) qui est fixé sur la plaquette de circuits imprimés (11', 11 ") présente un élément de fond (8a) et un élément de retenue (8b), et l'âme (7a) de l'élément câblé (7) est maintenue par l'élément de retenue (8b) plié en direction de la plaquette de circuits imprimés (11', 11"), sachant qu'un contact électrique entre un connecteur de la plaquette de circuits imprimés (11', 11 ") et l'âme du câble (7a) est établi en même temps.

12. Manette (1) selon la revendication 10 ou 11, **caractérisée en ce que** l'élément de sertissage (8) pénètre la plaquette de circuits imprimés (11', 11') et l'élément de retenue (8b) maintient l'âme du câble (7a) sur le côté supérieur de la plaquette de circuits imprimés (11', 11"), sachant que l'élément de fond (8a) repose sur le côté inférieur de la plaquette de circuits imprimés (11', 11 ").

13. Manette (1) selon l'une quelconque des revendications précédentes, **caractérisée en ce que** la plaquette de circuits imprimés (11', 11") présente une surface brasée, en particulier une ouverture brasée (16), sur laquelle l'élément câblé (7) est fixé par liaison de matière.

14. Manette (1) selon l'une quelconque des revendications précédentes, **caractérisée en ce que** la surface de communication (12) et la plaquette de circuits imprimés (11', 11 ") sont liées par un fil métallique mince.

15. Manette (1) selon l'une quelconque des revendications précédentes, **caractérisée en ce que** la surface de communication (12) et la plaquette de circuits imprimés (11', 11 ") sont collées avec une colle conductrice qui présente des charges métalliques ou sont reliées par un contact à ressort, un contact à fiche ou un plastique conducteur.

16. Manette (1) selon l'une quelconque des revendications précédentes, **caractérisée en ce que** l'élément support (4) et/ou la plaquette de circuits imprimés (11', 11 ") sont entourés par un corps enveloppe (15), ce qui entraîne l'apparition d'une unité modulaire préconfectionnée.

17. Manette (1) selon l'une quelconque des revendications précédentes, **caractérisée en ce que** l'élément câblé (7) dépasse de la surface de communication (12) extrudée, en particulier la surface de communication extrudée (12) présente des broches de contact (14) pour la liaison avec la plaquette de circuits imprimés (11', 11 "), lesquelles dépassent de la paroi intérieure (2b) du boîtier (2).

18. Manette (1) selon l'une quelconque des revendications précédentes, **caractérisée en ce que** la surface de communication (12) est une tôle métallique ou **en ce que** la surface de communication (12) est un revêtement métallique mince.

19. Manette (1) selon l'une quelconque des revendications précédentes, **caractérisée en ce que** la surface de communication (12) est disposée sur l'élément support (4).

20. Manette (1) selon l'une quelconque des revendications précédentes, **caractérisée en ce que** la plaquette de circuits imprimés (11 ") présente des éléments de fixation qui permettent de maintenir de manière amovible la plaquette de circuits imprimés (11 ") sur l'élément support (4).

21. Manette (1) selon l'une quelconque des revendications précédentes, **caractérisée en ce que** la plaquette de circuits imprimés (11', 11 ") est coulée dans l'espace creux (3), en particulier avec l'élément support (4) et/ou avec la surface de communication (12),
